# DEMANDE DE BREVET EUROPEEN

(11) **EP 1 271 547 A1**
(43) Date de publication de la demande: **02.01.2003**
(21) Numéro de dépôt: 01810587.4
(22) Date de dépôt: 18.06.2001
(51) Int. Cl.: G11C 11/404, G11C 11/403, H01L 27/108

(54) **Dispositif semi-conducteur, notamment mémoire DRAM**

(71) Demandeur: Innovative Silicon SA, 1015 Lausanne (CH); Ecole Polytechnique Fédérale de Lausanne (EPFL), 1015 Lausanne (CH)
(72) Inventeur: Fazan, Pierre, 2525 Le Landeron (CH); Okhonin, Serguei, 1005 Lausanne (CH)
(74) Mandataire: Vinsome, Rex Martin

(57) **Abrégé**

Dispositif semi-conducteur comportant un substrat (13) muni d'une couche isolante (12) et, formé sur celle-ci, au moins un transistor (32) qui comprend une source (18), un drain (22), un corps (20) interposé entre la source et le drain, une grille (28) jouxtant ledit corps et un film diélectrique (26) interposé entre la grille (28) et le corps (20).

Ce dispositif comporte, en outre des moyens de commande (46) pour créer une charge électrique dans le corps (20) et des moyens de lecture (48) pour déterminer un paramètre fonction de cette charge.

## Description

La présente invention se rapporte aux dispositifs semi-conducteurs, du type comportant un substrat muni d'une couche isolante et, formé sur celle-ci, au moins un transistor qui comprend une source, un drain, un corps interposé entre la source et le drain, une grille jouxtant le corps et un film diélectrique interposé entre la grille et le corps. On notera que, dans ce dispositif, le substrat peut être formé d'un isolant dans toute sa masse ou d'une couche isolante disposée sur une plaquette en matériau semi-conducteur ou conducteur.

La partie de la cellule appelée "corps" correspond à sa portion communément nommée du terme anglais "body", comprise entre la source et le drain.

On appellera "couche" la matière recouvrant le substrat de manière homogène dans ses dimensions et sa composition, et "strate" la matière dont la composition et/ou l'épaisseur peuvent présenter des différences respectivement de composition, dues au dopage, et/ou d'épaisseur dues à des opérations de gravure ou de dépôt localisé.

Certains de ces dispositifs à effet de champ, de type MOSFET (de l'anglais Metal Oxyde Semiconductor Field Effect Transistor)' font appel à des technologies appelées SOI (de l'anglais Silicon On Insulator) ou SOS (de l'anglais Silicon On Sapphire). La technologie SOI est généralement développée sur un substrat en silicium portant une couche de dioxyde de silicium, laquelle est revêtue d'une couche de silicium dans laquelle sont formés les composants électroniques. En technologie SOS, le substrat est en matériau isolant, du saphir par exemple, ou encore du verre ou du quartz, revêtu d'une couche de silicium sur laquelle sont formés les composants électroniques.

Comme expliqué dans le document intitulé "Suppression of Parasitic Bipolar Action in Ultra-Thin-Film Fully-Depleted CMOS/SIMOX Devices by Ar-Ions Implantation into Source/Drain Regions", publié par Terukazu Ohno et al. dans IEEE Transactions on Electron Devices, Vol. 45, No 5, May 1998, des dispositifs faisant appel à cette technologie comportent un corps qui peut être chargé électriquement sous certaines conditions, puisque disposé dans un environnement électriquement isolant. Cette publication explique les mesures à prendre pour éviter ce phénomène.

Le but de la présente invention est, au contraire, de tirer profit de la présence de cette charge, laquelle joue le rôle de support pour le traitement d'informations. A cet effet, le dispositif selon l'invention est caractérisé en ce qu'il comporte, en outre des moyens de commande pour créer une charge électrique dans le corps et des moyens de lecture pour déterminer un paramètre fonction de cette charge.

Dans un premier mode de réalisation, le dispositif comprend une pluralité de transistors disposés selon une structure matricielle et formant ensemble une mémoire, chaque transistor pouvant être individuellement commandé par les moyens de commande et lu par les moyens de lecture, et formant ainsi une unité d'information.

Il est de la sorte possible de réaliser une mémoire de type DRAM (de l'anglais Dynamic Random Access Memory) occupant un minimum de place. L'espace nécessaire est, en effet, sensiblement réduit par rapport aux solutions connues, par exemple celle décrite dans le document US 3,387,286, appelée 1T/1C, pour 1 transistor/1 condensateur, ou ses évolutions récentes telles que celles décrites dans la publication intitulée « Highly Manufacturable 4 Gb DRAM Using 0.11 µm DRAM Technology», H.S. Jeong et al. IEDM 2000, pages 353 et suivantes. Ce gain de place provient du fait que le porteur de la charge définissant l'état de la mémoire est directement associé au transistor lui-même.

Dans le dispositif selon l'invention, et dépendant de la configuration des moyens de commande, la charge créée dans le corps peut avoir une valeur négative, positive ou nulle. L'unité d'information est agencée pour prendre, à partir des signaux appliqués par les moyens de commande, un premier état correspondant à une première de ces valeurs et un deuxième état correspondant à une autre de ces valeurs. Ainsi, l'unité d'information peut avoir deux états correspondant l'un à **0**, l'autre à **1**, permettant ainsi la réalisation de mémoires de type binaires.

Il est également possible de travailler en logique ternaire, l'unité d'information étant agencée pour pouvoir prendre un troisième état, correspondant à la troisième des valeurs de la charge. En d'autres termes, selon que la charge est négative, nulle ou positive, la valeur en mémoire est égale à **0, 1** ou **2**.

Afin de réduire au maximum la place occupée par chaque unité de mémoire, la source et le drain d'une part, au moins, des transistors sont respectivement communs avec l'un des deux transistors adjacents.

Dès lors que l'information est mise en mémoire par la création d'une charge électrique, il est nécessaire de rafraîchir périodiquement les informations, la charge tendant à décroître par recombinaison et génération de porteurs. C'est pourquoi le dispositif comporte, en outre des moyens pour rafraîchir l'information stockée dans chacune des unités d'information.

Dans un deuxième mode de réalisation, le dispositif assure une fonction de capteur. A cet effet, le transistor est agencé de manière à ce que la charge dans le corps varie en fonction du temps et d'au moins un autre paramètre physique, et en ce que les moyens de lecture sont agencés de manière à déterminer la valeur de la charge en relation avec le temps, pour permettre la détermination de la valeur de l'autre paramètre.

La présente invention se rapporte également à une mémoire DRAM formée sur un substrat comportant une pluralité d'unités de mémoire et présentant une structure matricielle, chaque unité correspondant à un point de la matrice.

Le terme de mémoire est à prendre ici au sens large, se rapportant également aux mémoires DRAM embarquées, c'est-à-dire associées, sur une même puce, à un ou plusieurs autres dispositifs électroniques, tels qu'un microprocesseur par exemple, appelées aussi EDRAM ou eDRAM.

Le coût, la capacité de mémoire et la vitesse sont fonction de l'espace occupé par chaque unité, lequel est d'autant plus grand que le nombre de composants est élevé. Dans les mémoires connues, chaque unité est formée de deux composants, soit, un transistor et un condensateur. Afin de réduire cet espace, la mémoire DRAM selon l'invention est caractérisée en ce qu'une part au moins desdites unités est constituée d'un seul composant, agencé pour permettre la création et la rétention de manière temporaire d'une charge électrique.

De manière avantageuse, le composant est un transistor à effet de champ. Il est formé sur un substrat comportant une couche isolante revêtue d'une couche de silicium.

D'autres avantages et caractéristiques de l'invention ressortiront de la description qui va suivre, faite en regard du dessin annexé, dans lequel:
- La figure 1 représente un transistor SOI à effet de champ de type MOSFET;
- Les figures 2 et 3 montrent les séquences des signaux à appliquer au dispositif pour y créer une charge respectivement positive et négative dans un transistor N-MOS;
- La figure 4, illustre la variation du courant mesuré entre la source et le drain du transistor considéré, en fonction de la tension appliquée sur la grille;
- Les figures 5 et 6 sont des représentations schématiques d'une portion de mémoire réalisée au moyen du dispositif selon l'invention; et
- Les figures 7 et 8 montrent respectivement en plan et en coupe la structure de la portion du dispositif dont le schéma est illustré par la figure 6, la figure 8 étant une coupe selon la ligne A-A de la figure 7.

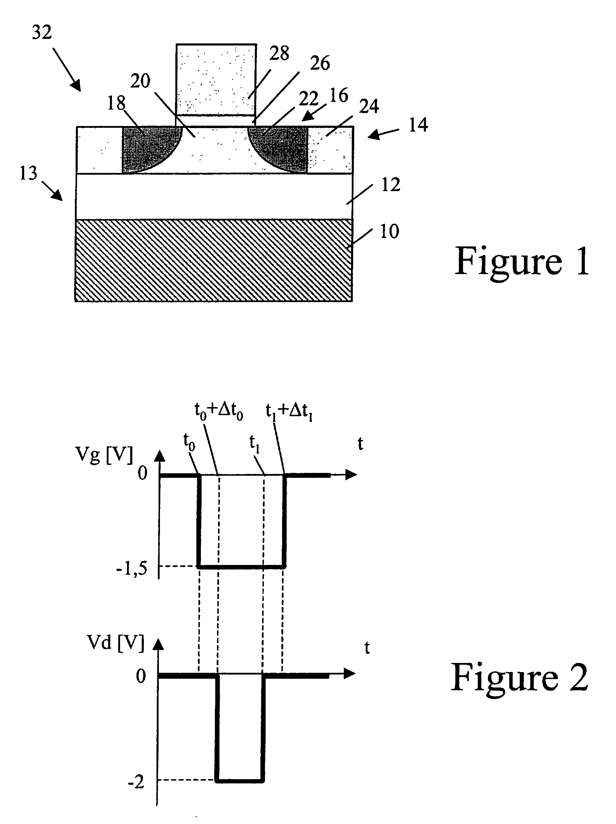

La portion de dispositif selon l'invention représentée sur la figure 1 comprend une plaquette en silicium 10, revêtue d'une couche 12 en dioxyde de silicium et formant ensemble un substrat 13. Ce demier porte une strate 14 formée d'un îlot 16 en silicium dopé localement pour former une source 18, un corps 20 et un drain 22, et d'une structure alvéolaire isolante 24 en dioxyde de silicium, l'alvéole étant remplie par l'îlot 16. Un film diélectrique 26 recouvre le corps 20. Il est lui-même recouvert par une grille 28 en matériau semi-conducteur dopé. La grille 28, la source 18, le corps 20 et le drain 22, forment ensemble un transistor à effet de champ 32.

Toutes les informations relatives au procédé de fabrication et les compositions chimiques des différentes parties définies ci-dessus, et plus particulièrement les conditions de dopage, se trouvent dans un document intitulé "SOI: Materials to Systems", A. J. Auberton-Hervé, IEDM 96. Ce document montre, en outre, que les transistors de ce type présentent une instabilité électrique, du fait que le corps 20 est électriquement flottant, ce qui peut conduire à une présence de charges électriques dans celui-ci, selon la séquence des impulsions de tension appliquée au transistor 32.

Pour créer une charge positive dans un transistor de type N-MOS, et comme le montre la figure 2, les tensions de grille V_{g} et de drain V_{d} sont nulles initialement. En un instant tₒ, la tension de grille est amenée à -1,5 V et, en un instant t₀ + Δt₀ (Δt₀ étant plus grand, plus petit ou égal à zéro), la tension de drain V_{d} est amenée à - 2V. En d'autres termes, les tensions de grille et de drain peuvent être commutées simultanément ou légèrement décalées dans un sens ou dans l'autre.

A partir de cet instant, il se forme un chemin de conduction dans le corps 20, qui relie la source 18 au drain 22, permettant la circulation de particules chargées à cause de l'augmentation de la conductivité de ce chemin. La tension de drain V_{d} repasse ensuite, en un instant t₁, à une tension nulle, alors que la tension de grille V_{g} prend également une valeur nulle en un instant t₁ + Δt₁, (Δt₁ positif).

A titre indicatif et en l'état de la technique, le temps compris entre t₀ et t₁ est typiquement compris entre quelques nanosecondes et quelques dizaines de nanosecondes, alors que Δt₁ est de l'ordre de la nanoseconde.

Une telle séquence permet de créer une charge électrique positive dans le corps 20. La pratique a montré que cette charge ne pouvait être créée que dans la mesure où la tension de drain V_{d} commute de sa valeur négative à zéro avant la tension de grille V_{g}.

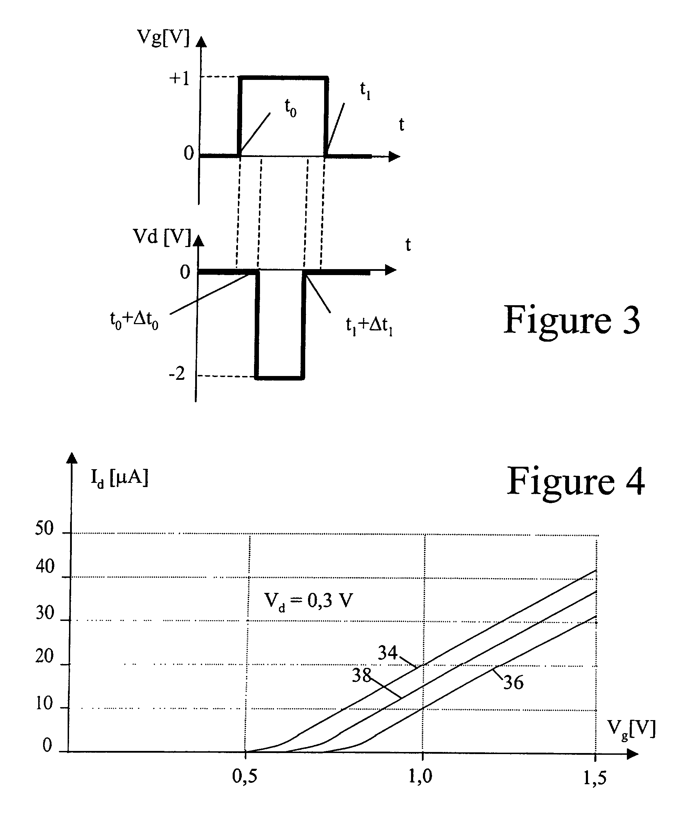

Il est également possible de créer une charge négative dans un transistor de type NMOS, en appliquant des tensions V_{d} et V_{g} selon la séquence représentée à la figure 3. Une telle charge peut être obtenue en amenant respectivement en des temps t₀ et t₀ + Δt₀ (Δt₀ nul, positif ou négatif), la tension de grille V_{g} à +1V et la tension de drain V_{d} à -2V, puis en ramenant respectivement ces tensions à 0V, en des temps t₁ et t₁ + Δt₁ (Δt₁ nul, positif ou négatif).

Si l'on applique une tension de drain V_{d} de 0,3V et une tension V_{g} variable, on obtient des courants tels que représentés sur la figure 4, mesurés à la sortie du drain 22, les courbes 34, 36 et 38 correspondant respectivement à des situations dans lesquelles le corps 20 porte une charge positive, négative et nulle, le courant mesuré allant croissant lorsque la charge électrique varie d'une valeur négative vers une valeur positive.

En appliquant donc des tensions calibrées à la grille 28 et au drain 22, et en mesurant le courant de drain I_{d}, il est possible de savoir si le corps 20 est chargé positivement, négativement ou neutre.

Un transistor tel que décrit peut être utilisé comme une unité ou une cellule de mémoire binaire, une charge positive correspondant, par exemple, à un **1** et une charge négative à un **0**. L'état de l'unité de mémoire peut ainsi être lu de manière différentielle, en comparant le courant circulant entre source et drain d'un transistor de référence, non chargé, avec le transistor considéré.

Il va de soi qu'une charge électrique localisée dans un corps solide ne peut subsister de manière permanente. Les charges électriques migrent et se recombinent avec des charges de signe opposé, de manière plus ou moins rapide, en fonction de l'environnement, notamment de la température ou d'un rayonnement de particules, par exemple des photons, frappant le transistor.

Il est ainsi possible de faire appel à cette caractéristique pour réaliser un capteur à partir d'un transistor tel que décrit. Cela peut se faire en mesurant, par exemple, le temps nécessaire pour qu'un tel capteur voie sa charge diminuer d'un facteur donné, ce temps étant fonction du paramètre considéré. Il est également possible de disposer d'un ensemble de transistors de charges croissantes. Le numéro du transistor ayant une charge égale à une valeur de référence en un instant donné permet de déterminer la valeur du paramètre mesuré.

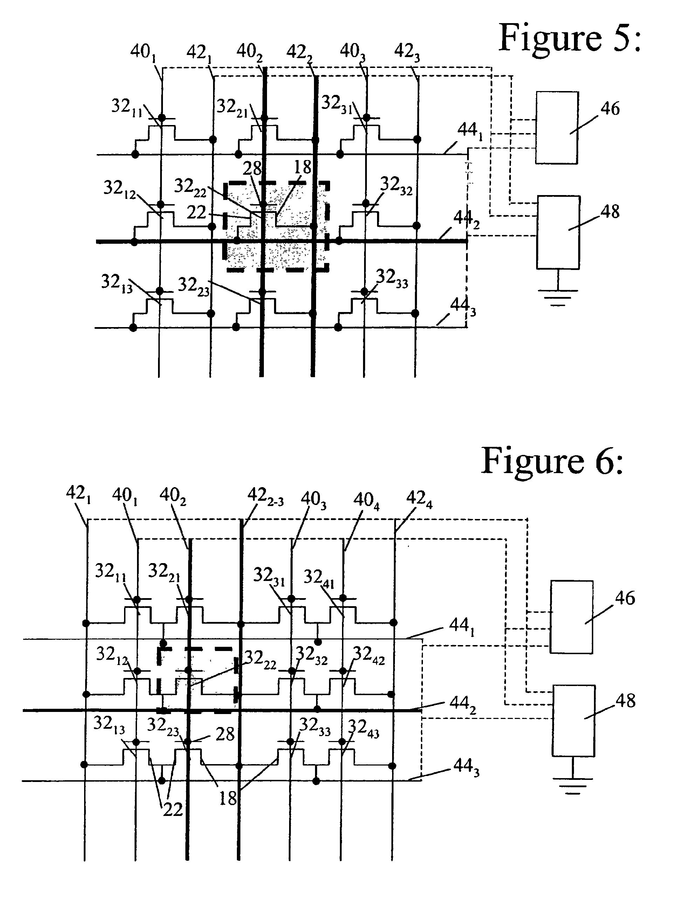

La figure 5 représente, de manière schématique, une portion de mémoire DRAM (de l'anglais Dynamic Random Access Memory), formée d'une matrice d'unités d'information, chaque unité étant constituée d'un transistor à effet de champ 32ᵢⱼ tel que décrit en référence à la figure 1, la référence i correspondant au rang de la ligne et la référence j au rang de la colonne de la matrice. Sur cette figure, le transistor 32₂₂ est grisé et entouré d'un rectangle afin de bien en identifier la surface occupée. Ces transistors sont commandés par trois champs de pistes conductrices 40ᵢ, 42ᵢ et 44ⱼ, les pistes 40ᵢ et 42ᵢ étant respectivement reliées aux grilles 28 et aux sources 18 des transistors d'une même ligne i et les pistes 44ⱼ aux drains 22 des transistors d'une même colonne j.

Les pistes 40, 42 et 44 sont toutes reliées à des circuits électroniques assurant respectivement une fonction de moyen de commande 46 et de moyen de lecture 48. Comme évoqué plus haut, de tels circuits sont bien connus de l'homme du métier. Ils ne sont, en conséquence, pas représentés de manière autre que schématique. Dans cette mémoire, toutes les sources sont reliées à la masse au travers des moyens de lecture. Elles pourraient être aussi reliées à un potentiel fixe donné. On relèvera que, de manière avantageuse, la lecture sera effectuée par une mesure de courant plutôt que de tension.

L'écriture du contenu des unités d'information s'effectue en créant une charge électrique dans le transistor 32ᵢⱼ qui la constitue. A cet effet, toutes les pistes 44 de rang différent de j sont à un potentiel égal à zéro, alors que la piste 44ⱼ est amenée un potentiel égal à -2V. Parallèlement, toutes les pistes 40 de rang différent de i sont à un potentiel égal à -2V. La piste 40ᵢ est amenée à un potentiel égale à -1,5V pour écrire un **1** et à +1V pour écrire un **0**. La tension de drain, appliquée par la piste 44ⱼ, est ensuite ramenée au potentiel de 0V, avant que la tension de grille, appliquée par la piste 40ᵢ ne soit ramenée à -2V, afin d'être certain qu'une charge a été créée, qu'elle soit positive ou négative.

La lecture des informations en mémoires se fait en amenant la tension des pistes 40 de rang différent de i à une tension égale à 0V, alors que la piste 40ᵢ est à 1V, et la tension des pistes 44 de rang différent de j à 0V, alors que la piste 44ⱼ est à +0,3V. Une mesure du courant dans la piste 44ⱼ permet, comme expliqué en référence à la figure 4, de déterminer si la charge créée est positive ou négative, c'est-à-dire si le contenu de la mémoire est égal à **1** ou **0**.

Les tensions appliquées sur les pistes 40 et 44 sont choisies de manière à permettre l'écriture et la lecture de la charge du corps 20 d'un transistor 32ᵢⱼ sans modifier celle des autres transistors. Les modes d'écriture et de lecture décrits ci-dessus permettent de modifier et de connaître le contenu d'une unité d'information. Il est bien entendu que d'autres procédures, par ailleurs connues, peuvent sans autres être appliquées à ce dispositif.

Avec la configuration de mémoire illustrée à la figure 5, chaque unité est formée d'un transistor 32 disposé dans la structure alvéolaire isolante 24. Comme le montre la figure 6, qui représente une vue schématique d'une autre structure de mémoire DRAM, il est possible de réduire considérablement la surface occupée par chaque unité de mémoire en disposant les transistors de manière à ce que, dans une colonne, chaque transistor, à l'exception de ceux disposés aux extrémités, a respectivement son drain et sa source en commun avec l'un et l'autre de ses plus proches voisins de la même colonne. Il est ainsi possible de réduire d'un facteur presque égal à 2 le nombre de pistes 42 et le nombre de connections sur les pistes 44.

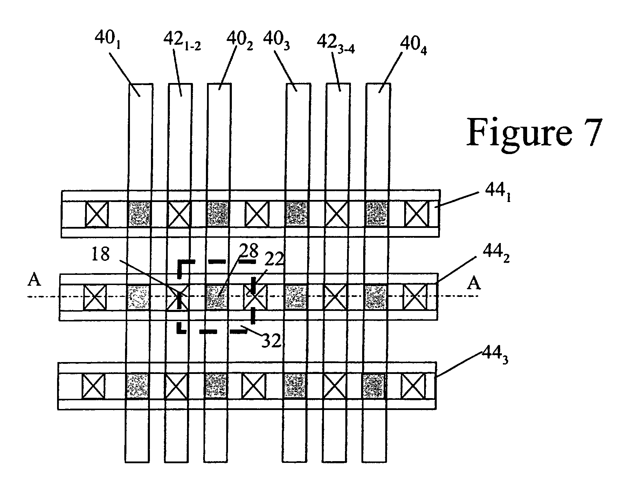

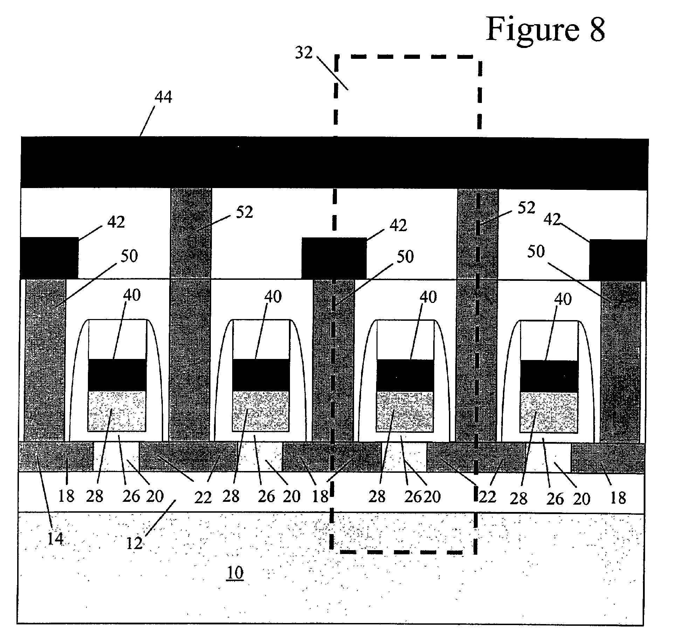

La figure 8 montre la portion de cellule de la figure 7, vue en coupe selon la ligne A-A. Sur cette figure, les mêmes parties portent les mêmes références que sur la figure 1. On peut donc y voir la plaquette 10 et la couche isolante 12, les sources 18, les corps 20 et les drains 22.Les films diélectriques 26 se prolongent sur les côtés des grilles 28. Les sources 18 sont reliées, par paires, à une piste 42 par un pilier 50, et les drains 22, également par paires, à une piste 44,au moyen d'un pilier 52.

Les mémoires telles que décrites en références aux figures 5 à 8 sont de type dynamique ou volatile. Il est donc nécessaire de rafraîchir périodiquement leur contenu. Cela peut se faire par une alternance de lecture et d'écriture, une portion de la charge détectée lors de la lecture étant complétée dans le transistor considéré. La périodicité du rafraîchissement est typiquement comprise entre 1 milliseconde et 1 seconde. Une description plus complète des moyens mis en oeuvres pour permettre ce rafraîchissement se trouve dans l'ouvrage "DRAM Circuit Design", ISBN 0-7803 6014-1.

Il est bien évident que le dispositif décrit peut faire l'objet de nombreuses variantes, sans pour autant sortir du cadre de l'invention. Il est, sans autre, possible de réaliser un tel dispositif avec des transistors de type PMOS, les moyens à mettre en oeuvre pour créer une charge étant inversés en regard de ce qui vient d'être décrit en référence aux transistors NMOS.

La création d'une charge peut également se faire de manière différente. Il est ainsi possible de créer une charge positive dans un transistor NMOS et négative dans un transistor PMOS par un mécanisme d'ionisation par impact, réalisé lorsque, pour un transistor de type NMOS, V_{g} passe de 0 à 1V puis revient à zéro, alors que V_{d} passe de 0 à 2V et revient à zéro. Les potentiels sont inversés avec un transistor PMOS.

Il est également possible de travailler en logique ternaire, en différenciant les transistors chargés positivement, négativement ou non chargés.

Les matériaux mis en oeuvre pour la réalisation de tels dispositifs peuvent aussi faire l'objet de nombreuses variantes. Ainsi, la strate 14 de silicium pourrait être remplacée par une strate en d'autres matériaux semi-conducteurs, de type mono-cristallin, poly-cristallin ou amorphe, comme le germanium ou l'arséniure de gallium par exemple.

Il est aussi évident que les périodes, tensions et courants mentionnés sont des exemples relatifs à un mode de réalisation particulier et que ces paramètres peuvent considérablement varier en fonction des moyens mis en oeuvre, sans pour autant sortir du cadre de l'invention.

Il apparaît ainsi qu'il est possible de réaliser des mémoires de type DRAM nécessitant un minimum de place, grâce au fait que chaque unité est constituée d'un seul composant, en l'occurrence un transistor. Cette économie de place joue aussi un rôle important dans le domaine des capteurs. Cela est spécialement vrai pour la mesure de la lumière, où chaque transistor peut mesurer un point lumineux, les points étant très rapprochés les uns des autres. Cela permet d'augmenter la résolution de prises de vues ou de réduire la surface du capteur.

## Revendications

1. Dispositif semi-conducteur comportant un substrat (13) muni d'une couche isolante (12) et, formé sur celle-ci, au moins un transistor (32) qui comprend une source (18), un drain (22), un corps (20) interposé entre la source et le drain, une grille (28) jouxtant ledit corps et un film diélectrique (26) interposé entre la grille (28) et le corps (20),
**caractérisé en ce qu'**il comporte, en outre des moyens de commande (46) pour créer une charge électrique dans ledit corps (20) et des moyens de lecture (48) pour déterminer un paramètre fonction de ladite charge.

2. Dispositif selon la revendication 1 **caractérisé en ce qu'**il comporte une pluralité de transistors (32) disposés selon une structure matricielle et formant ensemble une mémoire, chaque transistor pouvant être individuellement commandé par les moyens de commande (46) et lu par les moyens de lecture (48), et formant une unité d'information.

3. Dispositif selon la revendication 2, **caractérisé en ce que** ladite charge peut avoir une valeur négative, positive ou nulle, et **en ce que** ladite unité est agencée pour prendre un premier état (**0**) correspondant à l'une desdites valeurs et un deuxième état (**1**) correspondant à une autre desdites valeurs.

4. Dispositif selon la revendication 3, **caractérisé en ce que** ladite unité est agencées pour prendre un troisième état (**2**), correspondant à la troisième desdites valeurs.

5. Dispositif selon l'une des revendications 2 à 4, **caractérisé en ce que** la source (18) et le drain (22) d'une part au moins desdits transistors (32) sont respectivement communs avec l'un des deux transistors adjacents.

6. Dispositif selon l'une des revendications 1 à 5, **caractérisé en ce qu'**il comporte, en outre des moyens pour rafraîchir l'information stockée dans chacune desdites unités.

7. Dispositif selon la revendication 1, **caractérisé en ce que** ledit transistor (32) est agencé de manière à ce que sa charge varie en fonction du temps et d'au moins un autre paramètre physique, et **en ce que** lesdits moyens de lecture (48) sont agencés de manière à déterminer la valeur de la charge en relation avec le temps, pour permettre la détermination de la valeur de l'autre paramètre.

8. Mémoire DRAM formée sur un substrat (13) comportant une pluralité d'unité de mémorisation présentant une structure matricielle, chaque unité correspondant à un point de la matrice, **caractérisée en ce que** une part au moins desdites unités est constituée d'un seul composant, agencé pour permettre la création et la rétention de manière temporaire d'une charge électrique.

9. Mémoire selon la revendication 8, **caractérisée en ce que** ledit composant est un transistor à effet de champ (32).

10. Mémoire selon l'une des revendications 8 et 9, **caractérisée en ce que** ledit substrat (13) comporte une couche isolante (12) revêtue d'une couche de silicium (14) dans laquelle est formé une part au moins dudit composant (32).
